Europäisches Patentamt

European Patent Office

Office européen des brevets

(11) Publication number: **0 170 856 B1**

## EUROPEAN PATENT SPECIFICATION

(45) Date of publication of patent specification: **18.09.91**

(51) Int. Cl.⁵: **C30B 15/02**, C30B 15/12, C30B 15/14

(21) Application number: **85107878.2**

(22) Date of filing: **25.06.85**

(54) **Process for growing monocrystals of semiconductor materials from shallow crucibles by Czochralski technique.**

(30) Priority: **06.07.84 US 628377**

(43) Date of publication of application:
**12.02.86 Bulletin 86/07**

(45) Publication of the grant of the patent:
**18.09.91 Bulletin 91/38**

(84) Designated Contracting States:
**DE FR GB IT**

(56) References cited:
**FR-A- 1 302 043**
**FR-A- 2 371 228**
**GB-A- 939 102**
**US-A- 2 977 258**

**PATENTS ABSTRACTS OF JAPAN, vol. 7, no. 118 C-167)[1263], 21st May 1983; & JP - A - 58 36 997 (FUJITSU K.K.) 04-03-1983**

(73) Proprietor: **GENERAL SIGNAL CORPORATION PO Box 10010 High Ridge Park Stamford Connecticut 06904(US)**

(72) Inventor: **Lane, Richard L.**
**1350 Penfield Center Road**
**Penfield New York(US)**

(74) Representative: **Baillie, Iain Cameron et al c/o Ladas & Parry Isartorplatz 5 W-8000 München 2(DE)**

### Description

Technical Field

The present invention concerns processes for growing monocrystals of semiconductor materials for use in making microelectronic and photovoltaic devices, for example. More particularly, the invention concerns such processes which operate in accordance with the familiar Czochralski technique in which a monocrystal of semiconductor material is pulled continuously from a crucible of molten material while both the crystal and the crucible are rotating.

Background Art

The manufacture of integrated circuit devices requires the ready availability of high grade semiconductor materials, such as silicon, for use as substrates on which the integrated circuit devices are built up layer by layer. To have optimum assurance that the properties of the substrate will be uniform, it is necessary that each substrate be prepared from a single crystal of semiconductor material. Three basic processes have been developed which are used, in preference to other known processes, to grow monocrystals of sufficient quality for use in semiconductor device manufacture. These are the float zone process, the dendritic web process and the Czochralski process.

In the float zone process, a rod of polycrystalline semiconductor material is fed upward or downward through an annular induction coil heater so that a molten, floating zone of the material is established. A seed of monocrystalline material is used to draw from this molten zone a much larger monocrystal of the material. This process produces good quality monocrystals typically having very few crystalline dislocations, axially uniform levels of impurities and a very low oxygen content. Float zone silicon is often characterized by rather high resistivity. The process is rather slow and expensive, requiring considerable operator skill and experience for best results. Impurities and surface defects cannot be eliminated by oxygen gettering due to the low concentration of oxygen in the crystal. Also, float zone silicon substrates have been found to be dimensionally unstable during processing of integrated circuit devices, apparently due to their lack of oxygen impurities.

In the dendritic web process, a small volume quartz crucible is used to melt rather small amounts of semiconductor materials, typically in the range of 0.15 to 0.25 kilograms. The crucible is typically held stationary (that is, not rotated or raised and lowered) within an annular radio frequency induction heating coil which provides the energy necessary to melt the semiconductor material. Crucible rotation would produce a circular thermal symmetry which would preclude dendritic ribbon growth which requires an asymmetrical thermal profile. A seed crystal of a particular crystallographic structure is used to pull a ribbon of monocrystalline material from highly super-cooled liquid in the crucible. The ribbon is not rotated during withdrawal. The process is very sensitive to small changes in the temperature of the molten material; so, rather small, shallow crucibles and complex top heat shields are used to minimize convective movement of the material which would cause undesirable temperature variations. U.S. Patent No. 3,129,061 granted to Dermatis et al, discloses a typical apparatus and process for producing monocrystals by the dendritic web process. Replenishment of the shallow crucible is known, but only where neither the crucible nor the crystal are rotating. Approximately 10 percent of the melt can be pulled each hour by the process, so that the ribbon is formed rather slowly and replenishment proceeds slowly, too.

In the Czochralski process, large crucibles are used which typically can melt about 20.0 to 40.0 kilograms of material. Such crucibles are typically 30.0 to 40.0 centimeters in diameter and 20.0 to 30.0 centimeters in depth, though even larger crucibles are being used to accommodate demand for larger monocrystals. The crucible is surrounded by an elongated cylindrical resistance heater and supported on a pedestal which can be rotated as well raised and lowered within the heater. A seed of monocrystalline material is inserted into the molten material within the crucible and as the seed and crucible are rotated, the seed is gradually withdrawn bringing with it a much larger, monocrystalline rod of semiconductor material. To maintain the crystallization front at an essentially constant height relative to the surrounding heater, the crucible is slowly lifted as the crystal is withdrawn and the volume of the molten material or melt within the crucible decreases. Production of monocrystals by the Czochralski process is approximately ten times faster than the dendritic web process when the area of crystal produced is considered and approximately thirty times faster than the dendritic web process when the weight of crystal produced is considered. It is also appreciably faster than float zone.

Although very substantial improvements have been made over the years in the equipment used to grow monocrystals using the Czochralski process, two intrinsically unavoidable problems have remained with conventional Czochralski equipment. First, the continuously changing conditions from the start of a run to its completion manifest themselves as gradual macroscopic non-uniformities both axially and radially in the crystal. During a typical cycle, the melt depth decreases, the crucible rises, the crystal becomes larger, the heater power is varied and purge gas flow patterns change. As a result, for example, impurity and oxygen concentration gradients are formed. Although some oxygen inclusions in the monocrystal are desirable since they function as getters for metal impurities that diffuse into the crystal during processing of semiconductor devices, it is desirable that the concentration of such inclusions be relatively uniform both axially and radially within the crystal. In crystals made by conventional Czochralski techniques, the axial variation in oxygen concentration is quite significant, ranging from approximately 40 ppma at the center of the crystal near the seed end to approximately 20 ppma near the tail of the crystal. The radial variation at the seed end is also substantial with the outer edges of wafers cut from the seed end dropping off from about 40 ppma at the center to about 30 ppma oxygen at the outer edge. At the tail end of the crystal, the oxygen concentration typically is low at about 20 ppma but relatively uniform radially. Such oxygen enters the melt by dissolution from the material of the crucible. The change in concentration along the crystal occurs because the melt-to-crucible interface gets smaller as the melt level drops, thus reducing the source of oxygen for inclusion in the crystal.

A second, unavoidable problem with the conventional Czochralski technique is that uncontrolled, short term thermal fluctuations at the crystallization front are common as a result of turbulent convection in the melt caused by density or temperature gradients established in the deep crucible during crystal formation.

In general, any crucible whose depth is greater than about half its diameter will exhibit marked thermal instabilities at the crystallization front which can be partially offset by crystal and crucible rotation. This type of thermal turbulence causes microscopic non-uniformities in the finished crystal, such as impurity striations. These types of non-uniformities in crystals produced by conventional, deep crucible, large melt Czochralski equipment are particularly troublesome in processing of large scale integrated circuit devices using silicon substrates. In such applications, the silicon reacts non-uniformly during the processing steps required to fabricate the devices, leading to yield losses and degraded performance.

Other continuing problems with large diameter (30.0 to 40.0 cm) and large volume (30.0 to 40.0 kg) melts are increased difficulty in producing zero-dislocation crystals; longer melting and stabilizing time, expensive crucibles, lift mechanisms and heaters; large equipment size due to crucible lift mechanisms; safety hazard of large volume in case of a spill; and difficulty controlling crystal shape.

Thus, although the Czochralski technique continues to be favored for manufacture of monocrystals of semiconductor material, a need has continued to exist for improvements to the process which would both minimize the thermal turbulence which causes microscopic non-uniformities, and maintain an essentially constant volume of melt to eliminate variations in oxygen concentrations within the crystal.

U.S. Patent 2,997,258 relates to a method of producing monocrystalline semiconductor crystals utilizing a crucible and dam and a single heat source, the bottom of the crucible providing an outer melting chamber and an inner crystallizing chamber of different depths. French Patent 2371228 relates to a similar method but with a crucible providing an outer melting chamber separate from, and at a higher level than, an inner crystallizing chamber.

According to the present invention there is provided a method for producing monocrystals of semiconductor material according to the Czochralski method in which semiconductor material is fed to a crucible and a monocrystalline rod of the semiconductor material is withdrawn from the crucible, characterized by the fact that it comprises the steps of:

(a) placing a cylindrical dam inside a crucible having a substantially flat bottom wall and a peripheral sidewall, said dam defining an outer annular volume into which granular semiconductor material is added and from which said material flows into the inner volume of the crucible interiorly of the dam through at least one aperture in the dam adjacent said bottom wall, a quantity of granular semiconductor material in the crucible such that the ratio of the melt depth d to the diameter D of the dam is in the range of 0.021 to 0.313;

(b) controlling the rate of feed of the granular material to the outer annular volume of the crucible to maintain said depth d at a substantially constant value throughout substantially the entire period of growth of the monocrystal;

(c) controlling a first heating means to maintain the temperature of the material near the center of the crucible at a magnitude suitable for crystallization of the material;

(d) controlling a second heating means to maintain the temperature in the outer annular volume of the crucible at a magnitude suitable for melting the granular material;

(e) flushing the interior of a chamber enclosing the crucible with an inert gas; and

(f) rotating the crucible during crystal growth.

Figure 1 shows an elevational, partly schematic and partly sectioned view of an apparatus for producing monocrystals of semiconductor material in accordance with the invention.

Figure 2 shows a view taken along line 2-2 of Figure 1.

Figure 3 shows an elevation view, partly in section, of a feeder for granular material suitable for use in the apparatus according to the invention.

Figure 4 shows an elevational schematic view in section, of a preferred type of feeder for granular material suitable for use in the apparatus according to the invention.

Figure 5 shows a schematic view of a means for controlling the rate of feed of granular material by monitoring the rate of change in weight of the crystal.

Figure 6 shows a schematic view of a means for controlling the rate of feed of granular material by monitoring the level of the molten material in the crucible.

The following is a detailed description of a preferred embodiment of the invention, reference being made to the drawings in which like reference numerals identify like elements of structure in each of the several Figures.

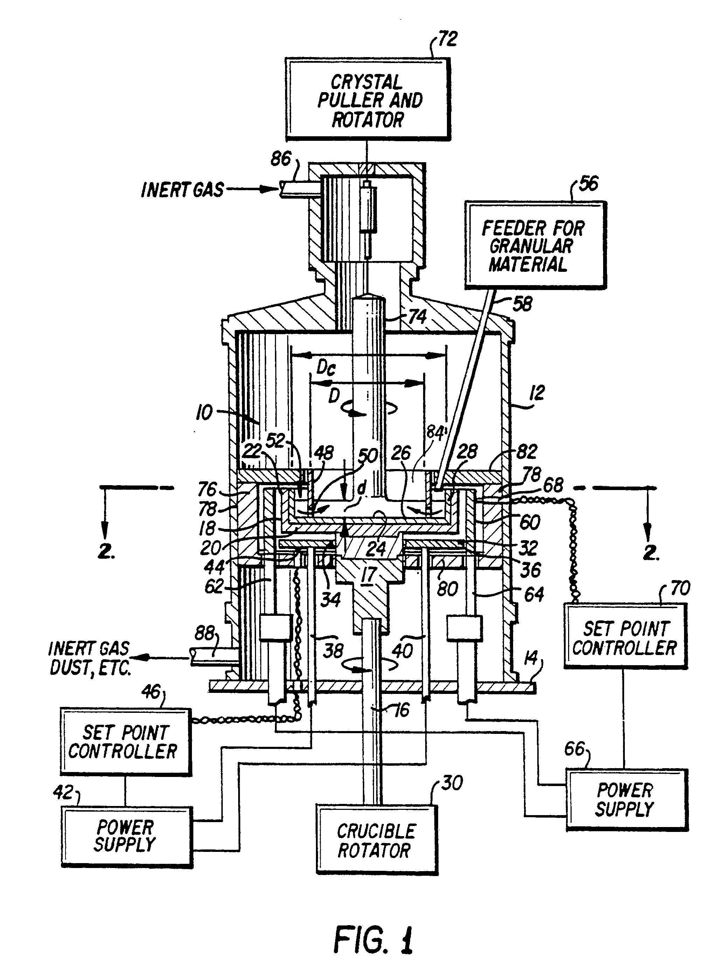

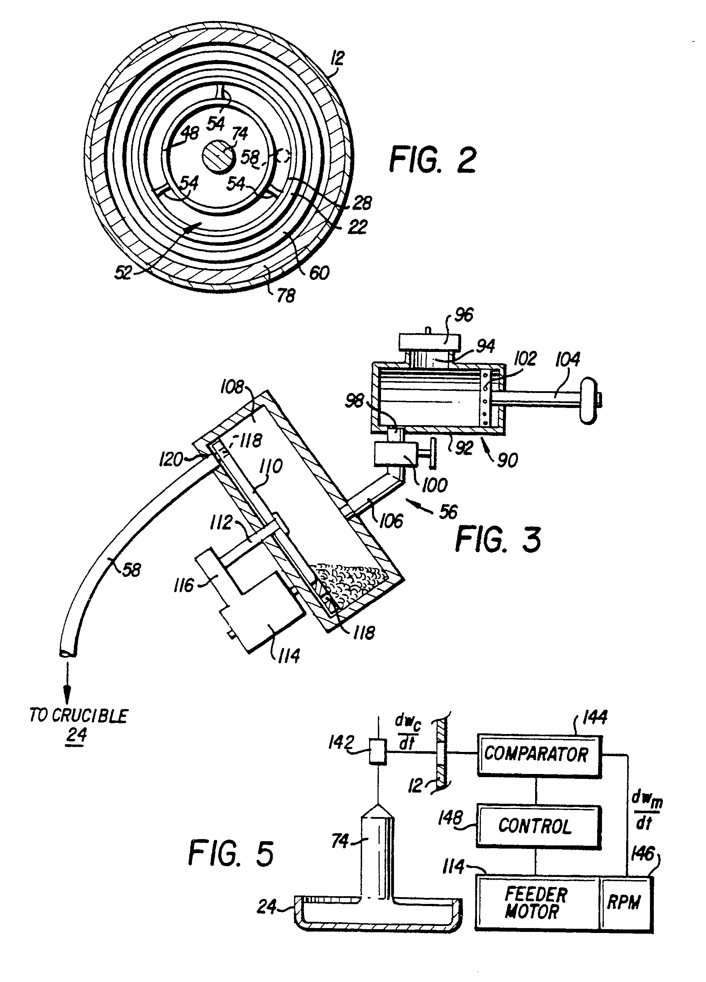

Figures 1 and 2 illustrate the apparatus according to the invention in which an enclosed chamber 10 is defined by a surrounding essentially cylindrical housing 12 supported on a base 14. Extending upwardly through suitable seals in base 14, not illustrated, is a crucible support shaft 16 which includes at its upper end a pedestal 17 on which a crucible support bowl 18 is mounted. Bowl 18, which may be made from a material such as graphite, includes an essentially flat bottom support wall 20 and an integral, upwardly extending peripheral support wall 22. Within support bowl 18 is positioned a quartz crucible 24 having a bottom wall 26 and an upwardly extending, peripheral side wall 28. Side wall 28 has an inner diameter $D_c$, as indicated in Figure 1. In use, crucible 24 is filled to a depth d with molten material. In accordance with the invention, it has been determined that the ratio of d to $D_c$ should be in the range of 0.019 to 0.250 to minimize thermal convection and turbulence in the molten material to levels at which concentrations of impurities on a microscopic scale remain essentially constant throughout the crystal. Preferably, the crystal diameter to be made in a given crucible should not exceed 40.0 to 60.0 percent of the diameter $D_c$. A suitable crucible rotating means 30 of known design is provided which may produce an infinitely variable speed of rotation for shaft 16, support bowl 18 and crucible 24 during operation. Because the material in crucible 24 is replenished so that the melt level remains essentially constant, no crucible lifting mechanism is required during crystal growth to maintain an essentially fixed crystallization front. However, a mechanism for adjusting the elevation of the crucible may be desirable to establish the optimum location of the melt with relation to the surrounding heaters. Once such an optimum vertical position has been established, the crucible would remain in a fixed vertical position during the growth cycle.

Positioned beneath support bowl 18 is a flat, annular resistance heater 32 having an inside diameter 34 surrounding the upper end of pedestal 17 and an outside diameter 36 extending just beyond the outside diameter of support bowl 18. Power for heater element 32 is provided through a pair of electrodes 38,40 which extend downwardly through base 14 and are connected to a power supply 42. A temperature detector 44 of known design is provided which measures the temperature of heater element 32. As will be appreciated by those skilled in the art, the temperature of the heater element can be correlated to the temperature of the molten material in crucible 24 at a location near the crystallization front. The output from temperature detector 44, which may be a simple thermocouple or the like, is directed to a set point controller 46 of known design which adjusts the output of power supply 42 so that the temperature at the crystallization front can be maintained at the desired range to promote crystallization.

Within crucible 24 is positioned an annular dam element 48 having an inside diameter D, also made of quartz and having an axial height preferably equal to or greater than the overall depth of crucible 24. Around the lower end of dam element 48 are provided a plurality of radial flow passages 50 which permit the flow of molten material toward and away from the center of crucible 24, from and to an annular volume 52 defined between dam element 48 and peripheral side wall 28. As shown in Figure 2, a plurality of spider arms 54 may be provided on the exterior wall of dam element 48 to position it radially relative to crucible 24. For a crystal of a given diameter, the radial distance between the crystallization front and the dam element will influence the oxygen concentration in the crystal. For example, as the dam element is moved closer to the crystal growth area, the oxygen content will increase. This is because the ratio will drop between the free melt surface area exposed to the interior of housing 12 and the area of melt exposed to the dam element, causing more oxygen to be retained in the material. The ratio of d to D should be in the range of 0.021 to 0.313, to minimize thermal convection and turbulence.

As shown schematically in Figure 1, a feeder 56 is provided for depositing granular semiconductor material, such as silicon pellets of 0.5 to 3.5 mm diameter, in annular volume 52. Feeder 56 preferably is positioned outside housing 12 and includes a quartz feed tube 58 which extends down into chamber 10 and terminates just below the rim of crucible 24 within annular volume 52. The dam element prevents scum or other debris from the pellets from moving toward the center of crucible 24 and also minimizes the effect of splashing when the pellets drop into annular volume 52.

To ensure that during pulling of the crystal the temperature within annular volume 52 is high enough to reliably melt pellets fed through feed tube 58, a cylindrical resistance heater element 60 is positioned around support bowl 18, heater element 60 having an inside diameter somewhat larger than the outside diameter of peripheral support wall 22 and an axial height extending from the bottom of heater element 32 to the upper edge of crucible 24. A pair of electrodes 62,64 extend downward from heater element 60 through base 14 and are connected to a further power supply 66. As in the case of heater element 32, a temperature detection means 68 of known design is provided which detects the temperature of heater element 60 near its upper edge. This temperature can be correlated in the manner familiar to those skilled in the art with the temperature existing within annular volume 52. The output of detector 68 is fed to a set point controller 70 of known design which adjusts the output of power supply 66 to ensure that the temperature in annular volume 52 remains in the desired range for melting pellets of material coming through feed tube 58.

A conventional crystal pulling and rotating mechanism 72 is used to insert a seed of monocrystalline material, not illustrated, into a melt of material in crucible 24 and then pull the crystal from the melt while rotating it so that a monocrystal 74 is produced. As crystal 74 is withdrawn from the crucible, the regulated feed of pellets through feed tube 58 ensures that the volume of molten material within crucible 24 remains constant, as will be discussed in further detail with regard to Figure 3.

To help maintain an essentially constant temperature profile within crucible 24, an insulation pack 76 is provided which may be made, for example, from fibrous graphite or quartz material. Insulation pack 76 comprises a peripheral wall 78 positioned just outside heater element 60 in contact with the interior surface of housing 12 and a bottom wall 80 through which pedestal 17 and electrodes 38,40 and 62,64 extend. The top wall 82 of pack 76 comprises a central opening 84 having an inner diameter somewhat larger than the outer diameter of dam element 48. To minimize particulate or gaseous contamination of the melt, dam 48 preferably extends at least into opening 84. Thus, top wall 82 helps to retain heat in annular volume 52 to facilitate melting of pellets introduced through feed tube 58. At the top of housing 12, an inlet 86 is provided for inert flushing gas which flows downward within the apparatus, through the annular opening between dam 48 and central opening 84 and then outward radially above the surface of molten material within annular volume 52, where the flushing gas entrains any gas-borne dust or debris carried into the apparatus through feed tube 58. The flushing gas then flows downwardly between support bowl 18 and heater 60, through bottom wall 80 and leaves the housing through an outlet duct 88.

In operation of the apparatus described thus far, crucible 24 first is filled with a charge of pellets of semiconductor material. For a crucible 40.0 centimeters in diameter and 2.0 centimeters deep, a charge of 6.38 kilograms would be used, for example. Heating elements 32 and 60 are then turned on to melt the material. When silicon semiconductor material is being melted, the required furnace temperature is approximately 1475 degrees celsius. After the charge of material has completely melted, the heaters are adjusted so that the temperature at the center of the crucible drops to a level of approximately 1415 to 1420 degrees celsius. On the other hand, the temperature in annular volume 52 is maintained in the range of 1425 to 1450 degrees celsius to ensure that pellets fed through feed tube 58 will be melted sufficiently quickly. In apparatuses operating in accordance with the invention using a shallow depth crucible, the seed type, crystal pull rate, semiconductor materials, crystal size and purge gas all can be essentially the same as with conventional Czochralski systems.

Once the temperatures have been adjusted for pulling a crystal, a seed crystal is lowered by means 72 until it enters the molten material. The solid-liquid interface is established by surface tension and thermal effects at an elevation somewhat above the surface of the melt. This localized region is somewhat supper-cooled, the remainder of the melt being at a temperature above the melting point. Once the desired conditions have been reached, the seed is slowly withdrawn in the familiar manner while crucible 24 and the seed are rotated. As the size of the crystal increases, additional material is added to annular volume 52 to maintain a constant melt volume. Silicon pellets made by the fluidized bed process are considered best; however, any uniformly sized pellets or particles of the required electronic grade of purity can be used in accordance with the invention.

Figure 3 shows a schematic view of feeder 56 for granular material. A batch feeder 90 for pellets or grains of semiconductor material comprises an essentially horizontal cylinder 92 having an inlet port 94 on its upper side, the inlet port being provided with a closure 96. On the lower side of cylinder 92, and outlet port 98 is provided through which granular material can pass toward an isolation valve 100. To move granular material from cylinder 92, a piston 102 is positioned within the cylinder and actuated via a suitable mechanism or manually by means of a handle 104. A batch of granules or pellets can be swept from cylinder 92 by piston 102, through isolation valve 100 and into a delivery tube 106 which empties into a tilted pellet feed chamber 108. Within chamber 108, the pellets fall to the bottom of the chamber, as illustrated, where they contact the upper surface of a pellet feed disk 110. A shaft 112 extends through the wall of chamber 108 and rotatably supports feed disk 110 for rotation by a variable speed motor 114 acting through a suitable reduction gear box 116. Feed disk 110 comprises one or more pellet receptor bores 118 which fill with pellets each time disk 110 is rotated through the pile of pellets at the bottom of chamber 108. A small amount of pellets thus is carried by disk 110 toward its upper end where the pellets drop from disk 110 into a discharge port 120 which opens to the upper end of feed tube 58, through which the pellets fall into annular volume 52 in the manner previously discussed. Thus, by controlling the rate of rotation of feed disk 110, it is possible to accurately control the rate at which pellets are picked up and dropped through feed tube 58. Knowing the average weight of the pellets, the weight-rate at which material is added to annular volume 52 can be matched to the rate at which the weight of crystal 74 increases during operation. In a shallow crucible system according to the invention, it is estimated that approximately 50 percent of the melt can be pulled each hour; so, the capacity of feeder 56 should be set accordingly. A feeder of this type could also be used to add dopants to the melt separately.

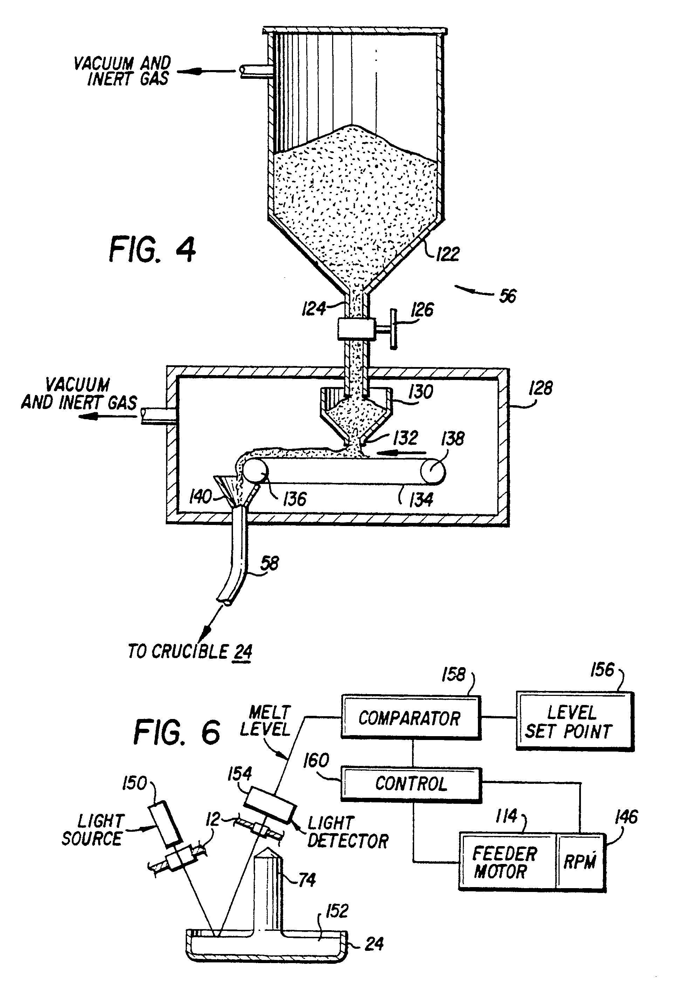

Figure 4 shows a schematic view of another preferred feeder 56 for granular material. Storage and recharge hopper 122 contains a large supply of pellets or grains of semiconductor material. Preferably, hopper 122 is purged with inert gas and maintained at a slight vacuum. The discharge conduit 124 of hopper 122 passes through a suitable isolation valve 126, which is closed when hopper 122 is recharged. The lower end of conduit 124 extends into a feed chamber 128 which also is purged with inert gas and maintained at a slight vacuum. Within chamber 128, a feed hopper 130 is positioned to receive pellets or grains from conduit 124. The discharge conduit 132 of feed hopper 130 extends to an elevation just above the upper surface of a flexible conveyor belt 134 which extends around a pair of rollers 136,138, one of which is driven by a variable speed motor having an rpm counter, not illustrated but similar to motor 114 in Figure 3 and counter 146 in Figure 5. The discharge end of belt 134 is positioned above a collector cone 140 which empties into feed tube 58. By adjusting the position of discharge conduit 132 above conveyor belt 134, as those skilled in the material conveying arts will appreciate, material can be caused to flow from conduit 132 only when belt 134 is moving. Similarly, the lower end of discharge conduit 124 can be positioned within feed hopper 130 so that material will flow into feed hopper 130 only when the level of material within feed hopper 130 drops below the lower end of discharge conduit 124. The exact positions of the lower ends of conduits 124 and 132 will depend in a given application on the flow properties of the material being fed, the diameters of the discharge conduits and related factors. Output into feed tube 58 is a continuous stream of pellets or particles at a rate dependent on the speed of conveyor belt 134. The storage hopper 122 may be refilled periodically while valve 126 is closed, without interrupting flow into feed tube 58.

Figure 5 illustrates schematically one apparatus for controlling the operation of feeder 56 of either Figure 3 or 4. A suitable weight sensor 142 of known design is included in the linkage which lifts and rotates crystal 74 so that the rate of increase in the weight of the crystal can be determined. A signal proportional to this rate of increase is fed to a comparator 144 positioned outside housing 12, the comparator also being arranged to receive a signal proportional to the rate of rotation of motor 114 via an rpm counter 146. Depending upon the difference between these two rates, an error signal will be developed and sent to a controller 148 which adjusts the speed of motor 114 as necessary to ensure that pellets are added at the appropriate rate to maintain a constant melt volume.

Figure 6 shows another apparatus suitable for controlling the operation of feeder 56 of either Figure 3 or 4. In this case, a light source 150, such as a laser beam projector, is used to direct a beam of light onto the surface 152 of the molten material within crucible 24. The beam of light reflects from this surface to a light detector 154 and, depending upon the height of surface 152, the position of the reflected beam will change in proportion. A signal proportional to the melt level thus is sent from detector 154 to a comparator 158 which also receives a signal proportional to the desired melt level from a set point signal generator 156. Any difference between these two signals is directed to a controller 160 which adjusts the speed of motor 114 in the manner previously described.

## Claims

1. A method for producing monocrystals of semiconductor material according to the czochralski method in which semiconductor material is fed to a crucible and a monocrystalline rod of the semiconductor material is withdrawn from the crucible, characterized by the fact that it comprises the steps of:

(a) placing a cylindrical dam inside a crucible having a substantially flat bottom wall and a peripheral sidewall, said dam defining an outer annular volume into which granular semiconductor material is added and from which said material flows into the inner volume of the crucible interiorly of the dam through at least one aperture in the dam adjacent said bottom wall, a quantity of granular semiconductor material in the crucible such that the ratio of the melt depth d to the diamter D of the dam is in the range of 0.021 to 0.313;

(b) controlling the rate of feed of the granular material to the outer annular volume of the crucible to maintain said depth d at a substantially constant value throughout substantially the entire period of growth of the monocrystal;

(c) controlling a first heating means to maintain the temperature of the material near the center of the crucible at a magnitude suitable for crystallization of the material;

(d) controlling a second heating means to maintain the temperature in the outer annular volume of the crucible at a magnitude suitable for melting the granular material;

e) flushing the interior of a chamber enclosing the crucible with an inert gas; and

(f) rotating the crucible during crystal growth.

2. A method according to claim 1, characterized by the fact that the feed rate controlling step is effected by controlling the rate of feed of the granular semiconductor material to the outer annular volume of the crucible to substantially match the rate of increase in the weight of the withdrawn monocrystal.

3. A method according to claim 1, characterized by the fact that the feed rate controlling step is effected by monitoring the level of the liquid semiconductor material in the crucible, and adjusting the rate of feed of the granular semiconductor material to maintain a substantially constant melt level of the liquid semiconductor material.

4. A process according to any one of the preceding claims, characterized in that the ratio of the melt depth d to the diameter $D_c$ of the crucible is in the range of 0.019 to 0.250.

## Revendications

1. Procédé de production de monocristaux de matériau semi-conducteur selon la méthode de Czochralski dans lequel le matériau semi-conducteur est introduit dans un creuset et une barre monocristalline de matériau semi-conducteur est retirée du creuset, caractérisé par le fait qu'il comprend les étapes suivantes :

(a) disposer dans un barrage cylindrique situé à l'intérieur d'un creuset ayant une paroi inférieure sensiblement plate et une paroi latérale périphérique, ledit barrage définissant un volume annulaire externe dans lequel est introduit un matériau semi-conducteur granulaire et duquel ledit matériau s'écoule dans le volume interne du creuset à l'intérieur du barrage par au moins une ouverture dans le barrage adjacente à ladite paroi inférieure, une quantité de matériau semi-conducteur granulaire dans le creuset telle que le rapport de la profondeur d de matériau fondu au diamètre D du barrage est compris dans la gamme de 0,021 à 0,313 ;

(b) contrôler la vitesse d'introduction du matériau granulaire dans le volume annulaire externe du creuset pour maintenir ladite profondeur d à une valeur sensiblement constante pendant sensiblement toute la période de croissance du monocristal ;

(c) contrôler un premier moyen chauffant pour maintenir la température du matériau à proximité du centre du creuset à une valeur convenant à la cristallisation du matériau ;

(d) contrôler un second moyen chauffant pour maintenir la température à l'intérieur du volume annulaire externe du creuset à une valeur convenant à la fusion du matériau granulaire ;

(e) balayer par un gaz inerte l'intérieur d'une chambre entourant le creuset, et

(f) faire tourner le creuset pendant la croissance du cristal.

2. Procédé selon la revendication 1, caractérisé par le fait que l'étape de contrôle de la vitesse d'introduction est effectuée en contrôlant la vitesse d'introduction du matériau semi-conducteur granulaire dans le volume annulaire externe du creuset de manière qu'elle coïncide sensiblement avec la vitesse d'augmentation du poids du monocristal retiré.

3. Procédé selon la revendication 1, caractérisé par le fait que l'étape de contrôle de la vitesse d'introduction est effectuée en surveillant le niveau du matériau semi-conducteur liquide dans le creuset et en réglant la vitesse d'introduction du matériau semi-conducteur granulaire pour maintenir un niveau sensiblement constant de matériau semi-conducteur liquide fondu.

4. Procédé selon l'une quelconque des revendications précédentes, caractérisé en ce que le rapport de la profondeur d de matériau fondu au diamètre $D_c$ du creuset est compris dans la gamme de 0,019 à 0,250.

**Patentansprüche**

1. Verfahren zur Herstellung von Einkristallen aus einem Halbleitermaterial nach dem Czochralski-Verfahren, bei dem Halbleitermaterial in einen Tiegel gegeben wird und ein einkristalliner Stab aus dem Halbleitermaterial aus dem Tiegel genommen wird, dadurch gekennzeichnet, daß das Verfahren die folgenden Schritte umfaßt:

(a) ein zylindrischer Überlauf mit einer im wesentlichen flachen Bodenwand und einer umlaufenden Seitenwand wird in dem Tiegel angeordnet, wobei der Überlauf eine äußere ringförmige Kammer bildet, in die gekörntes Halbleitermaterial gegeben wird, und von der das Material in den Innenraum des Tiegels innerhalb des Überlaufs durch mindestens eine Öffnung in dem Überlauf neben der Bodenwand fließt, und in den Tiegel wird eine Menge des gekörnten Halbleitermaterials gegeben, so daß das Verhältnis der Schmelztiefe d zum Durchmesser D des Überlaufs im Bereich von 0,021 bis 0,313 liegt;

(b) die Geschwindigkeit der Zuführung des gekörnten Materials zu der äußeren ringförmigen Kammer des Tiegels wird so gesteuert, daß die Tiefe d auf einem im wesentlichen konstanten Wert gehalten wird während im wesentlichen der ganzen Zeit des Wachstums des Einkristalls;

(c) eine erste Heizvorrichtung wird so gesteuert, daß die Temperatur des Materials in der Nähe der Mitte des Tiegels auf einer Höhe gehalten wird, die sich für die Kristallisation des Materials eignet;

(d) eine zweite Heizvorrichtung wird so gesteuert, daß die Temperatur in der äußeren ringförmigen Kammer des Tiegels auf einer Höhe gehalten wird, die geeignet ist, um das gekörnte Material zu schmelzen;

(e) das Innere einer den Tiegel umschließenden Kammer wird mit einem Edelgas gespült; und

(f) der Tiegel wird während des Züchtens der Kristalle gedreht.

2. Verfahren nach Anspruch 1, dadurch gekennzeichnet, daß der Schritt des Steuerns der Beschickungsgeschwindigkeit so durchgeführt wird, daß die Geschwindigkeit der Zuführung des gekörnten Halbleitermaterials zu der äußeren ringförmigen Kammer des Tiegels so gesteuert wird, daß sie im wesentlichen der Geschwindigkeit der Gewichtszunahme des entnommenen Einkristalls entspricht.

3. Verfahren nach Anspruch 1, dadurch gekennzeichnet, daß der Schritt des Steuerns der Beschickungsgeschwindigkeit so durchgeführt wird, daß der Pegel des flüssigen Halbleitermaterials in dem Tiegel überwacht wird, und die Beschickungsgeschwindigkeit des gekörnten Halbleitermaterials so eingestellt wird, daß ein im wesentlichen konstanter Schmelzpegel des flüssigen Halbleitermaterials aufrechterhalten wird.

4. Verfahren nach einem der vorhergehenden Ansprüche, dadurch gekennzeichnet, daß das Verhältnis der Schmelztiefe d zum Durchmesser $D_c$ des Tiegels im Bereich von 0,019 bis 0,250 liegt.

FIG. 1

EP 0 170 856 B1

FIG. 2

FIG. 3

TO CRUCIBLE
24

FIG. 5

$\frac{dw_c}{dt}$

COMPARATOR

CONTROL

$\frac{dw_m}{dt}$

FEEDER MOTOR | RPM

10

FIG. 4

VACUUM AND INERT GAS →

122

124  126  — 56

VACUUM AND INERT GAS ←  130  128

132  138

140  136  134

58

TO CRUCIBLE 24

FIG. 6

MELT LEVEL

158  COMPARATOR  156  LEVEL SET POINT

160  CONTROL

150  LIGHT SOURCE

12  154  LIGHT DETECTOR

74

152

24

114  FEEDER MOTOR  146  RPM

11